# EUROPEAN PATENT APPLICATION

(11) **EP 4 414 328 A1**
(43) Date of publication of application: **14.08.2024**
(21) Application number: 22878612.5
(22) Date of filing: 07.10.2022
(51) Int. Cl.: C01B 33/141, B01J 13/00, H01L 21/304

(54) **LINEAR COLLOIDAL SILICA PARTICLE DISPERSION SOL AND METHOD FOR PRODUCING SAME**

(30) Priority: 08.10.2021 JP 2021166421
(71) Applicant: Mitsubishi Materials Electronic Chemicals Co., Ltd., Akita-shi Akita 010-8585 (JP)
(72) Inventor: YAMAMOTO, Yuta, Akita-shi, Akita 010-8585 (JP)
(74) Representative: Hoffmann Eitle
(86) International application number: PCT/JP2022/037558
(87) International publication number: WO 2023/058745

(57) **Abstract**

Provided is a chainlike colloidal silica dispersion sol (16) formed by dispersing a group of colloidal silica particles having an average length of 35 nm to 1800 nm and an average of 4 to 300 spherical primary particles chainly connected that are grasped by field emission scanning electron microscopic observation in a solvent mixture (11) of pure water and an organic solvent. The average particle diameter of the spherical primary particles is 6 nm to 20 nm, the average aspect ratio of the spherical primary particles is within a range of 1.0 to 1.3, and the organic solvent is an alcohol having 1 to 4 carbon atoms or a water-soluble glycol compound having 2 to 4 carbon atoms. The content proportion of each impurity of K, Na or NH₃ per colloidal silica particle is 3500 ppm by mass or less, and the content proportion of each impurity of an alkali earth metal or aluminum is less than 1 ppm by mass.

## Description

### TECHNICAL FIELD

The present invention relates to a sol in which colloidal silica particles that are chainly connected spherical primary particles are dispersed and a method for producing the same. In more detail, the present invention relates to a chainlike colloidal silica dispersion sol enabling the formation of a film having a low refractive index when applied onto a base material and having favorable storage stability and a method for producing the same. In addition, the present invention relates to a film that is obtained using the chainlike colloidal silica dispersion sol.

Priority is claimed on Japanese Patent Application No. 2021-166421, filed October 8, 2021, the content of which is incorporated herein by reference.

### BACKGROUND ART

Conventionally, as this kind of silica sol, a stable silica sol having a SiO₂ concentration of 0.5 to 30 wt%, in which a ratio D₁/D₂ of a particle diameter measured by a dynamic light scattering method (D₁ µm) to a particle diameter measured by a nitrogen gas adsorption method (D₂ µm) is five or higher, this D₁ is 40 to 500 millimicrons, and amorphous colloidal silica particles each having a long and thin shape that elongate in a uniform thickness within a range of 5 to 40 millimicrons only in one plane when observed with an electronic microscope are dispersed in a liquid medium, has been disclosed (refer to Patent Literature 1 (Claim 1 to Claim 3, lines 5 to 9 in the upper right column on page 4)).

Claim 2 of Patent Literature 1 describes a method for producing an alkaline silica sol, including the following steps (a), (b) and (c):
(a) a step of adding and mixing an aqueous solution containing a water-soluble calcium salt, a water-soluble magnesium salt or a mixture thereof to and with a colloid aqueous solution of 1 to 6 wt% of activated silica, as SiO₂, having a pH of 2 to 4 as much as the weight ratio of CaO, MgO or both to the activated silica as SiO₂ reaches 1500 to 8500 ppm,
(b) a step of adding and mixing an alkali metal hydroxide, a water-soluble organic base or a water-soluble silica thereof to and with an aqueous solution obtained by the step (a) so that the mole ratio SiO₂/M₂O (where SiO₂ represents the amount of a silica component derived from the activated silica, and M represents the molecule of the above-described alkali metal atom or organic base) reaches 20 to 200, and
(c) a step of heating a mixture obtained by the step (b) at 60°C to 150°C for 0.5 to 40 hours.

Claim 3 of Patent Literature 1 describes the method for producing a stable alkaline aqueous silica sol according to Claim 2, in which, furthermore, the colloid aqueous solution of activated silica that is used in the step (a) is obtained by bringing an aqueous solution of sodium water glass having a SiO₂/Na₂O mole ratio of 1 to 4.5 and a SiO₂ concentration of 1 to 6 wt% into contact with a hydrogen-type cation exchange resin, has a SiO₂ concentration of 1 to 6 wt% and a pH of 2 to 4 and does not contain colloidal silica having a particle diameter of 3 millimicrons.

Patent Document 1 describes that the effect of this invention is to provide a stable silica sol exhibiting a performance improved by modifying the shapes of the colloidal silica particles and, furthermore, to provide a method for efficiently producing a silica sol relating to such improvement.

### CITATION LIST

### [Patent Literature]

[Patent Literature 1]
Japanese Unexamined Patent Application, First Publication No. H1-317115

### SUMMARY OF INVENTION

### Technical Problem

In the method for producing a silica sol having a long and thin shape disclosed in Patent Literature 1, the activated silica aqueous solution is obtained by passing the water glass, which is a raw material, through a column filled with the ion exchange resin. In this metal ion removal step, a lot of effort and time are required, which has created a problem of a poor efficiency.

In addition, since the aqueous solution containing a water-soluble calcium salt, a water-soluble magnesium salt or a mixture thereof is added to the colloid aqueous solution of activated silica, metal atoms, which are an impurity, are contained in the solution, and, as time passes, the metal particles of this impurity are eluted from the surfaces of the silica particles, needle-like impurities are precipitated, and storage stability lacks. Therefore, the silica sol that is obtained by the method of Patent Literature 1 has a problem of being not suitable for use in a field such as semiconductors where there is a concern regarding the influence of an impurity.

Incidentally, when high-purity spherical colloidal silica particles are used as a polishing agent in the use of chemical mechanical polishing (CMP), there is a demand for uniform particle diameters; however, in the case of forming a film using spherical colloidal silica particles, the particles in the film are likely to be closely packed, which creates a problem in that it is difficult to form a film having a low refractive index.

An objective of the present invention is to provide a chainlike colloidal silica dispersion sol enabling the formation of a film having a low refractive index when applied onto a base material and having favorable storage stability. Another objective of the present invention is to provide a method for easily producing this chainlike colloidal silica dispersion sol and a film having a low refractive index.

### Solution to Problem

The present inventors found that, when pure water is prepared in a predetermined proportion with respect to Si in an alkyl silicate, the alkyl silicate is dissolved in a solvent mixture of this pure water and an organic solvent in a predetermined proportion to prepare an alkyl silicate solution, and then a raw material liquid obtained by adding and mixing an alkali catalyst in a predetermined proportion to and with this solution is heated at a predetermined temperature for a predetermined time, colloidal silica particles are chainly (linearly) connected and reached the present invention.

A first aspect of the present invention is a chainlike (linear) colloidal silica dispersion sol formed by dispersing a group of colloidal silica particles having an average length of 35 nm to 1800 nm and an average of 4 to 300 spherical primary particles chainly connected that are grasped by field emission scanning electron microscopic observation in a solvent mixture of pure water and an organic solvent, in which an average particle diameter of the spherical primary particles is 6 nm to 20 nm, an average aspect ratio of the spherical primary particles is within a range of 1.0 to 1.3, the organic solvent is an alcohol having 1 to 4 carbon atoms or a water-soluble glycol compound having 2 to 4 carbon atoms, a content proportion of each impurity of K, Na or NH₃ per colloidal silica particle is 3500 ppm by mass or less, and a content proportion of each impurity of an alkali earth metal or aluminum is less than 1 ppm by mass.

A second aspect of the present invention is a method for producing the chainlike colloidal silica dispersion sol of the first aspect, the method including a step (a) of mixing an alkyl silicate having an alkyl group having 1 or 2 carbon atoms with a solvent mixture of pure water and an organic solvent to obtain an alkyl silicate solution, a step (b) of adding and mixing an alkali catalyst to and with the alkyl silicate solution to obtain a raw material liquid, and a step (c) of heating the raw material liquid at 40°C to 100°C for 24 hours to 100 hours, in which the pure water is contained in the solvent mixture in a proportion of 8 molar concentrations to 23 molar concentrations with respect to Si in the alkyl silicate, the organic solvent is an alcohol having 1 to 4 carbon atoms or a water-soluble glycol compound having 2 to 4 carbon atoms, in the step (a), when the alkyl silicate solution is set to 100 mass%, the alkyl silicate is mixed in a proportion of 18 mass% to 44 mass%, in the step (b), when the alkyl silicate is converted to silica, the alkali catalyst is mixed in a proportion of 0.02 mass% to 0.40 mass% with respect to the silica, and the alkali catalyst is an alkali metal hydroxide, ammonia or an alkylamine.

A third aspect of the present invention is an invention based on the second aspect that is the method for producing a chainlike colloidal silica dispersion sol, in which, in a heating initial stage of the step (c), spherical primary particles having an average aspect ratio of 1.0 to 1.1 and an average particle diameter of less than 5 nm are formed, and, at an end of the heating, the spherical primary particles in the heating initial stage have an average particle diameter of 6 nm to 20 nm and an average of 4 to 300 spherical primary particles chainly connected and grow to a group of colloidal silica particles having an average length of 35 nm to 1800 nm.

A fourth aspect of the present invention is a film that is obtained using the chainlike colloidal silica dispersion sol of the first aspect, in which a refractive index is 1.10 to 1.25. That is, the film of the fourth aspect of the present invention may be obtained by applying and then drying the chainlike colloidal silica dispersion sol of the first aspect on a base material.

### ADVANTAGEOUS EFFECTS OF INVENTION

Since the chainlike colloidal silica dispersion sol of the first aspect of the present invention is formed by dispersing the group of colloidal silica particles having an average length of 35 nm to 1800 nm and an average of 4 to 300 spherical primary particles chainly connected that are grasped by field emission scanning electron microscopic observation in a solvent mixture, when a film has been formed, pores are likely to be generated in the film, and the film has a low refractive index. In addition, since the average particle diameter of the spherical primary particles is 6 nm to 20 nm, the storage stability of the colloidal silica particle dispersion sol is favorable. Since the average aspect ratio of the spherical primary particles is within a range of 1.0 to 1.3, the chainlike colloidal silica dispersion sol has a low viscosity, and the formed film has a small variation in refractive index. In addition, since the content proportion of each impurity of K, Na or NH₃ per colloidal silica particle is 3500 ppm by mass or less, the spherical primary particles become chainlike. Furthermore, since the content proportion of each impurity of an alkali earth metal or aluminum in the chainlike colloidal silica dispersion sol is less than 1 ppm by mass, the particles do not coarsen even after the storage time elapses, and the chainlike colloidal silica dispersion sol has high storage stability.

In the method for producing a chainlike colloidal silica dispersion sol of the second aspect of the present invention, first, an alkyl silicate is dissolved in a solvent mixture to obtain an alkyl silicate solution, then, an alkali catalyst is added in a predetermined proportion to the alkyl silicate solution having a predetermined concentration of the alkyl silicate, and the alkyl silicate solution is heated at a predetermined temperature for a predetermined time. Since the alkyl silicate has a predetermined concentration, spherical primary particles become chainlike due to heating, and the alkyl silicate solution does not gelate. The addition of the alkali catalyst in a predetermined proportion generates spherical primary particles, and the heating of a raw material liquid at a predetermined temperature for a predetermined time increases the spherical primary particles to an average particle diameter of 6 nm to 20 nm and makes an average of 4 to 300 spherical primary particles chainly connected and grow to a group of colloidal silica particles have an average length of 35 nm to 1800 nm.

In the method for producing the chainlike colloidal silica dispersion sol of the third aspect of the present invention, at the end of the heating of the step (c), the spherical primary particles grow, and an average of 4 to 300 spherical primary particles chainly connected to become a group of colloidal silica particles having an average length of 35 nm to 1800 nm.

Since the film of the fourth aspect of the present invention is obtained using the chainlike colloidal silica dispersion sol of the first aspect, the particles in the film are likely not to be closely packed, and the film has a low refractive index of 1.10 to 1.25.

### BRIEF DESCRIPTION OF DRAWINGS

FIG. 1 is a flowchart of producing a chainlike colloidal silica dispersion sol of the present embodiment.
FIG. 2A is a photograph of chainlike colloidal silica particle groups after one hour of heating in Example 1 captured with a field emission scanning electron microscope (manufactured by Hitachi High-Tech Corporation, product No.: Regulus·230; hereinafter, referred to as FE-SEM).
FIG. 2B is an FE-SEM photograph of the chainlike silica particle groups after six hours of heating in Example 1.
FIG. 2C is an FE-SEM photograph of the chainlike silica particle groups after 24 hours of heating in Example 1.
FIG. 2D is an FE-SEM photograph of the chainlike silica particle groups after 48 hours of heating in Example 1.
FIG. 2E is an FE-SEM photograph of the chainlike silica particle groups after 72 hours of heating in Example 1.
FIG. 2F is an FE-SEM photograph of the chainlike silica particle groups after 96 hours of heating in Example 1.
FIG. 3 is an FE-SEM photograph of chainlike silica particle groups in Example 2.
FIG. 4 is an FE-SEM photograph of chainlike silica particle groups in Comparative Example 11.

### DESCRIPTION OF EMBODIMENTS

Next, an embodiment of the present invention will be described with reference to drawings.

### [Method for producing chainlike colloidal silica dispersion sol]

A chainlike colloidal silica dispersion sol of the present embodiment is schematically produced by the following method.

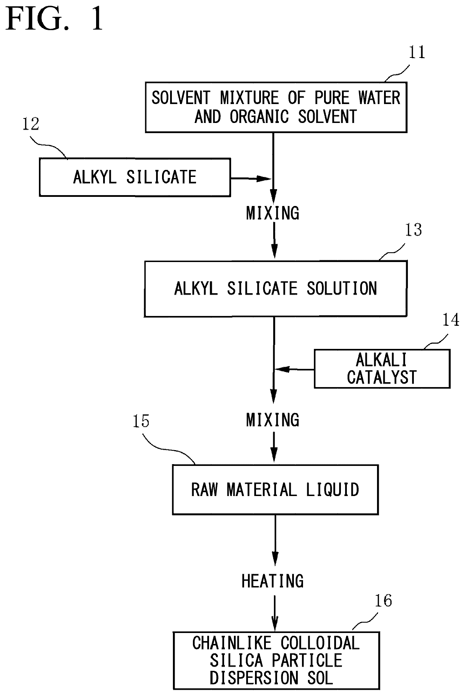

As shown in FIG. 1, an alkyl silicate 12 having an alkyl group having 1 or 2 carbon atoms is added to and mixed with a solvent mixture 11 of pure water and an organic solvent to obtain an alkyl silicate solution 13. Next, an alkali catalyst 14 is added to and mixed with this alkyl silicate solution 13 to obtain a raw material liquid 15. Next, this raw material liquid is heated at a temperature of 40°C to 100°C for 24 hours to 100 hours, thereby producing a chainlike colloidal silica dispersion sol 16.

### [Preparation of solvent mixture of pure water and organic solvent]

The organic solvent is an alcohol having 1 to 4 carbon atoms or a water-soluble glycol compound having 2 to 4 carbon atoms. Examples of the alcohol having 1 to 4 carbon atoms include methanol, ethanol, 2-propanol, n-propanol and butanol, and examples of the water-soluble glycol compound having 2 to 4 carbon atoms include ethylene glycol (having 2 carbon atoms), propylene glycol (having 3 carbon atoms), propylene glycol monomethyl ether (PGM) (having 4 carbon atoms), 1,3-butylene glycol (having 4 carbon atoms) and the like.

The solvent mixture 11 of pure water and the organic solvent is a solvent mixture of pure water or the alcohol having 1 to 4 carbon atoms or a solvent mixture of pure water and the water-soluble glycol compound having 2 to 4 carbon atoms. Such a solvent mixture easily dissolves alkyl silicates and is thus suitably used. In addition, the pure water in the solvent mixture is used for the hydrolysis of the alkyl silicate, and the organic solvent is used to enhance the compatibility of the pure water and the alkyl silicate.

The content proportion of the organic solvent in the alkyl silicate solution is preferably 10 mass% to 35 mass%. When the content proportion of the organic solvent is less than the lower limit value, it is difficult for spherical primary particles to grow and to sufficiently grow to chainlike particles. In addition, when the content proportion exceeds the upper limit value, spherical primary particles are likely to coarsen.

The amount of the pure water is adjusted so as to be 8 molar concentrations to 23 molar concentrations with respect to Si (silicon) in the alkyl silicate. When the amount is less than the upper limit value, spherical primary particles coarsen in a heating step. When the amount exceeds the upper limit value, the number of spherical primary particles are difficult to increase and do not sufficiently grow chainlike. The amount of the pure water is preferably 8 molar concentrations to 16 molar concentrations and more preferably 9 molar concentrations to 15 molar concentrations with respect to Si in the alkyl silicate.

### [Preparation of alkyl silicate solution]

The alkyl silicate solution 13 is prepared by adding and mixing the alkyl silicate 12 to and with the solvent mixture 11. The alkyl silicate 12 is a silicate having an alkyl group having 1 or 2 carbon atoms, which is easy to hydrolyze. Examples thereof include tetramethoxysilane (TMOS), tetraethoxysilane (TEOS), mixtures thereof and oligomers of an alkyl silicate. For example, trimers to pentamers of tetramethoxysilane (TMOS) (manufactured by Mitsubishi Chemical Corporation, trade name: MKC SILICATE MS51; hereinafter, also simply referred to as "MS51" in some cases) can be suitably used.

When the weight of the alkyl silicate solution 13 is set to 100 mass%, the alkyl silicate 12 is mixed in a proportion of 18 mass% to 44 mass%. When the proportion is less than the lower limit value, spherical primary particles are difficult to increase in the heating step. In addition, when the proportion exceeds the upper limit value, the number of primary particles connected is likely to become large, and, accordingly, chains are likely to become long. In addition, the alkyl silicate solution gelates. When the weight of alkyl silicate solution 13 is set to 100 mass%, the alkyl silicate 12 is preferably mixed in a proportion of 21 mass% to 43 mass% and more preferably mixed in a proportion of 26 mass% to 38 mass%.

The alkyl silicate solution is preferably prepared by stirring the alkyl silicate and the solvent mixture at a temperature of 0°C to 30°C for one minute to 30 minutes. The content proportion of the alkyl silicate in the alkyl silicate solution can be measured and obtained by nuclear magnetic resonance (NMR) (manufactured by Bruker, product No.: AVANCE III 400).

### [Preparation of raw material liquid]

The alkali catalyst 14 is added to and mixed with the alkyl silicate solution 13 in a proportion of, when the alkyl silicate is converted to silica, 0.02 mass% to 0.40 mass% with respect to this silica to prepare the raw material liquid 15. The alkali catalyst 14 is an alkali metal hydroxide, ammonia or an alkylamine. An alkali catalyst containing other alkali metal hydroxides or aluminum increases spherical primary particles, coarsens the particles and makes it difficult to increase the lengths of the chains of the primary particles in the heating step.

The use of such an alkali catalyst 14 makes the content proportion of an impurity of an alkali earth metal or aluminum per the final colloidal silica particle be less than 1 ppm by mass. As the alkali metal hydroxide, potassium hydroxide (KOH) or sodium hydroxide (NaOH) is exemplified, and, as the alkylamine, methylamine (CH₃NH₂), dimethylamine ((CH₃)₂NH), trimethylamine ((CH₃)₃N) and the like are exemplified. The alkali catalyst accelerates the hydrolysis of the alkyl silicate in the alkyl silicate solution 13 in the presence of pure water and the organic solvent. When the proportion of this alkali catalyst added is less than 0.02 mass%, which is the lower limit value, the reactivity is poor, spherical primary particles do not sufficiently grow, and it is difficult for the particles to become chainlike. When the proportion exceeds 0.40 mass%, which is the upper limit value, in the heating step, the hydrolysis is excessively accelerated, the reactivity becomes too high, and spherical particles are generated rather than chainlike particles. The raw material liquid is preferably prepared by stirring the alkali catalyst and the alkyl silicate solution at a temperature of 0°C to 30°C for one minute to 30 minutes. The proportion of this alkali catalyst added is preferably 0.02 mass% to 0.30 mass% and more preferably 0.05 mass% to 0.25 mass%.

### [Heating of raw material liquid and production of chainlike colloidal silica dispersion sol]

The raw material liquid 15 is heated at 40°C to 100°C for 24 hours to 100 hours. This makes spherical primary particles increase to an average particle diameter of 6 nm to 20 nm and makes an average of 4 to 300 spherical primary particles chainly connected and grow to a group of colloidal silica particles having an average length of 35 nm to 1800 nm. This group of colloidal silica particles is dispersed in the solvent mixture, and a chainlike colloidal silica dispersion sol is produced. The length of the chain varies with the proportion of the alkali catalyst added, the proportion of the alkali silicate added and the heating temperature. The average particle diameter of the spherical primary particles is the average value of particle diameters that are grasped by FE-SEM observation (the number of particle diameters grasped: 50). In addition, the average number of particles connected is the average of the numbers of particles connected that are grasped by FE-SEM observation (the number of the numbers of particles connected grasped: 50). Furthermore, the average length of the chainlike particles is the average value of lengths that are grasped by FE-SEM observation (the number of lengths grasped: 50). The heating temperature of the raw material liquid 15 is preferably 50°C to 85°C. The heating time of the raw material liquid 15 is preferably 24 hours to 72 hours.

The SiO₂ concentration of the chainlike colloidal silica dispersion sol of the present embodiment is preferably 10 mass% to 35 mass%. When the SiO₂ concentration is lower than the lower limit value, there is a concern that a film may not have a low refractive index when the film has been formed. In addition, when the SiO₂ concentration exceeds the upper limit value, SiO₂ is likely to aggregate in the chainlike colloidal silica dispersion sol. The SiO₂ concentration is more preferably 5 mass% to 10 mass%.

### [Characteristics of chainlike colloidal silica dispersion sol]

The chainlike colloidal silica dispersion sol of the present embodiment is produced by the above-described production method and is formed by dispersing the group of the colloidal silica particles having an average length of 35 nm to 1800 nm and an average of 4 to 300 spherical primary particles chainly connected that are grasped by FE-SEM observation in the solvent mixture of pure water and the organic solvent, the average particle diameter of the spherical primary particles is 6 nm to 20 nm, the average aspect ratio of the spherical primary particles is within a range of 1.0 to 1.3, the content proportion of each impurity of K, Na or NH₃ per colloidal silica particle is 3500 ppm by mass or less, and the content proportion of each impurity of the alkali earth metal or aluminum is less than 1 ppm by mass. The average aspect ratio of the spherical primary particles is the average value of numerical values obtained by dividing the major axis of each configuration particle by the minor axis and is calculated as an average value by individually obtaining the aspect ratios of 100 or more arbitrary particles. In addition, the concentrations of impurities other than NH₃ can be measured and obtained with an inductively coupled plasma (ICP) optical emission mass spectrometer (manufactured by PerkinElmer Co., Ltd., product No.: Avio 500). The concentration of the NH₃ impurity can be measured and obtained with an ammonia meter (manufactured by Tokokagaku Co., Ltd., product No.: TiN-9001).

When the average number of the colloidal silica particles connected is less than four, the refractive index of a film becomes high when the film has been formed, and, when the average number exceeds 300, the storage stability of the chainlike colloidal silica dispersion sol deteriorates. The average number of the colloidal silica particles connected is preferably 50 to 200. In addition, when the average chain length of the colloidal silica particles is less than 35 nm, the refractive index of a film does not become low when the film has been formed. In addition, when the average chain length exceeds 1800 nm, the storage stability of the chainlike colloidal silica dispersion sol deteriorates, and the chainlike colloidal silica dispersion sol gelates. The average chain length is preferably 50 nm to 1000 nm.

When the average particle diameter of the spherical primary particles is less than 6 nm, it is difficult for the particles to become chainlike, and, when the average particle diameter exceeds 20 nm, it is not possible to form a film or the refractive index of a film is likely to become high even if the film can be formed. The average particle diameter of the spherical primary particles is preferably 7 nm to 15 nm.

As the average aspect ratio of the spherical primary particles becomes closer to one, the viscosity of the chainlike colloidal silica dispersion sol becomes lower, and the variation in the refractive index of a film becomes smaller when the film has been formed. When the average aspect ratio of the spherical primary particles exceeds 1.3, the thicknesses of the chains of the colloidal silica particles become nonuniform. The refractive index of a coated film can be measured and obtained with a spectroscopic ellipsometer (manufactured by J. A. Woollam Japan, product No.: M-2000).

When the content proportion of each impurity of K, Na or NH₃ per colloidal silica particle exceeds 3500 ppm by mass, the reaction is excessively accelerated, the hydrolysis rate becomes too high, and the spherical primary particles do not become chainlike. When the content proportion of each impurity of the alkali earth metal or aluminum per colloidal silica particle becomes 1 ppm by mass or more, in the chainlike colloidal silica dispersion sol, the particles coarsen, and the storage stability deteriorates as the storage time elapses. The content proportion of each impurity of K, Na or NH₃ per colloidal silica particle is preferably 3000 ppm by mass or less and more preferably 2500 ppm by mass or less.

### (Method for forming chainlike colloidal silica dispersion sol on base material surface)

A method for forming the chainlike colloidal silica dispersion sol of the present embodiment on a base material surface is not particularly limited, and examples thereof include a method in which the chainlike colloidal silica dispersion sol is applied onto a base material and then dried at room temperature in the atmosphere to produce a film. This base material is not particularly limited, and examples thereof include a glass substrate, a silicon wafer, a resin substrate, a metal foil substrate and the like. Examples of a method for applying the chainlike colloidal silica dispersion sol include a spin coating method, a screen printing method, a bar coating method, a die coating method, a doctor blade method, a brush painting method and the like. The refractive index of the obtained film is 1.10 to 1.25. The use of the chainlike colloidal silica dispersion sol of the present embodiment makes it unlikely for the particles in the film to be closely packed and makes it possible to obtain a film having a low refractive index.

### EXAMPLES

Next, examples of the present invention will be described in detail with comparative examples.

### <Example 1>

A solvent mixture was prepared by mixing 63.5 g of ethanol and 63.5 g of pure water in a flask. The mass ratio between pure water and ethanol was 1: 1. A tetraethoxysilane solution was prepared by adding 73.0 g of tetraethoxysilane (TEOS) to this solvent mixture. The concentration of tetraethoxysilane in the tetraethoxysilane solution was 34.8 mass%. In addition, pure water was contained in a proportion of 11.6 molar concentrations with respect to Si in tetraethoxysilane. A raw material liquid was prepared by adding 10 g of a potassium hydroxide (KOH) aqueous solution dropwise as an alkali catalyst to the solution under stirring. Potassium hydroxide was added dropwise in a proportion of 0.12 mass% with respect to silica when tetraethoxysilane was converted to silica. After the dropwise addition of the potassium hydroxide aqueous solution, the raw material liquid was heated at 60°C for 96 hours, and the raw material liquid was aged. After the heating, the raw material liquid was slowly cooled to room temperature, thereby obtaining a chainlike colloidal silica dispersion sol. The solvent that had been evaporated or volatized by the heating was moved to a cooling system to be liquefied and returned to the raw material liquid.

Table 1 and Table 2 below show the preparation conditions of an alkyl silicate solution or the like and the preparation conditions of a raw material liquid in each of Example 1 and Examples 2 to 21 and Comparative Examples 1 to 11, which will be described below. In Comparative Example 11, a sodium silicate (Na silicate) aqueous solution was used instead of the alkyl silicate solution.

**TABLE 1**

| | Preparation conditions of alkyl silicate solution or the like | | | |
|---|---|---|---|---|
| | Alkyl silicate or the like | | Pure water | Organic solvent |
| | Kind | Proportion (mass%) | Proportion with respect to Si (molar concentration) | Kind |
| Example 1 | TEOS | 34.8 | 11.6 | Ethanol |
| Example 2 | TEOS | 26.1 | 23.0 | Ethanol |
| Example 3 | TEOS | 43.5 | 8.2 | Ethanol |
| Example 4 | TEOS | 34.8 | 9.6 | Propylene glycol monomethyl ether |
| Example 5 | TEOS | 34.8 | 7.6 | Ethanol |
| Example 6 | TEOS | 26.1 | 11.3 | Ethanol |
| Example 7 | TEOS | 34.8 | 11.7 | Ethanol |
| Example 8 | TEOS | 34.8 | 11.7 | Ethanol |
| Example 9 | TEOS | 348 | 11.7 | Ethanol |
| Example 10 | TEOS | 34.8 | 11.7 | Ethanol |
| Example 11 | MS51 + TEOS | 34.6 | 11.7 | Ethanol |
| Example 12 | TEOS | 34.8 | 11.6 | Ethanol |
| Example 13 | MS51 | 18.3 | 15.4 | Ethanol |
| Example 14 | TEOS | 34.8 | 11.6 | Methanol |
| Example 15 | TEOS | 34.8 | 11.6 | 2-Propanol |
| Example 16 | TEOS | 34.8 | 11.6 | n-Propanol |
| Example 17 | TEOS | 34.8 | 11.6 | Ethylene glycol |
| Example 18 | TEOS | 34.8 | 11.6 | Butanol |
| Example 19 | TEOS | 34.8 | 11.6 | Ethanol |
| Example 20 | TEOS | 348 | 11.6 | Ethanol |
| Example 21 | TEOS | 34.8 | 11.6 | Methanol |
| Comparative Example 1 | TEOS | 34.8 | 11.7 | Ethanol |
| Comparative Example 2 | TEOS | 34.8 | 11.7 | Ethanol |
| Comparative Example 3 | TEOS | 34.8 | 11.7 | Ethanol |
| Comparative Example 4 | TEOS | 60.8 | 4.2 | Ethanol |
| Comparative Example 5 | TEOS | 8.7 | 64.0 | Ethanol |
| Comparative Example 6 | TEOS | 34.8 | 1.6 | Propylene glycol monomethyl ether |
| Comparative Example 7 | TEOS | 34.8 | 1.6 | Ethanol |
| Comparative Example 8 | TEOS | 34.8 | 11.7 | Ethanol |
| Comparative Example 9 | TEOS | 69.5 | 2.9 | Ethanol |
| Comparative Example 10 | TEOS | 34.8 | 11.7 | Ethanol |
| Comparative Example 11 | Na silicate | 7.2 | 87.7 | Pure water |

**TABLE 2**

| | Preparation conditions of raw material liquid | | | Heating conditions | |
|---|---|---|---|---|---|
| | Alkyl silicate or the like | Alkali catalyst | | Temperature (°C) | Time (h) |
| | Kind | Kind | Proportion (mass%) | | |
| Example 1 | TEOS | KOH | 0.12 | 60 | 96 |
| Example 2 | TEOS | NaOH | 0.12 | 60 | 24 |
| Example 3 | TEOS | NaOH | 0.12 | 60 | 96 |
| Example 4 | TEOS | NaOH | 0.12 | 60 | 24 |
| Example 5 | TEOS | NaOH | 0.12 | 60 | 24 |
| Example 6 | TEOS | NaOH | 0.12 | 60 | 24 |
| Example 7 | TEOS | NaOH | 0.12 | 40 | 24 |
| Example 8 | TEOS | NH₃ | 0.12 | 60 | 48 |
| Example 9 | TEOS | NaOH | 0.02 | 60 | 24 |
| Example 10 | TEOS | NH₃ | 0.35 | 60 | 48 |
| Example 11 | MS51 + TEOS | KOH | 0.12 | 60 | 96 |
| Example 12 | TEOS | KOH | 0.12 | 100 | 24 |
| Example 13 | TEOS | KOH | 0.12 | 60 | 24 |
| Example 14 | TEOS | KOH | 0.12 | 60 | 24 |
| Example 15 | TEOS | KOH | 0.12 | 60 | 24 |
| Example 16 | TEOS | KOH | 0.12 | 60 | 24 |
| Example 17 | TEOS | KOH | 0.12 | 60 | 24 |
| Example 18 | TEOS | KOH | 0.12 | 60 | 24 |
| Example 19 | TEOS | CH₃NH₂ | 0.12 | 60 | 48 |
| Example 20 | TEOS | (CH₃)₂NH | 0.12 | 60 | 48 |
| Example 21 | TEOS | (CH₃)₃N | 0.12 | 60 | 48 |
| Comparative Example 1 | TEOS | Mg(OH)₂ | 0.12 | 60 | 24 |
| Comparative Example 2 | TEOS | AlCl₃ + NH₃ | 0.12 | 60 | 24 |
| Comparative Example 3 | TEOS | NaOH | 0.01 | 60 | 24 |
| Comparative Example 4 | TEOS | NaOH | 0.12 | 60 | 24 |
| Comparative Example 5 | TEOS | NaOH | 0.12 | 60 | 24 |
| Comparative Example 6 | TEOS | NaOH | 0.12 | 60 | 24 |
| Comparative Example 7 | TEOS | NaOH | 0.12 | 60 | 24 |
| Comparative Example 8 | TEOS | NH₃ | 0.60 | 60 | 24 |
| Comparative Example 9 | TEOS | NaOH | 0.12 | 60 | 24 |
| Comparative Example 10 | TEOS | NaOH | 0.70 | 60 | 24 |
| Comparative Example 11 | Na silicate | CaCl₂ + NaOH | 1.37 | 130 | 6 |

### <Examples 2 to 21 and Comparative Examples 1 to 10>

As shown in Table 1, regarding the preparation of the alkyl silicate solutions of Examples 2 to 21 and Comparative Examples 1 to 10, in Example 11, trimers to pentamers of tetramethoxysilane (TMOS) (manufactured by Mitsubishi Chemical Corporation, trade name: MKC SILICATE MS51) and tetramethoxysilane (TMOS) were used as alkyl silicates. The mixing ratio between MS51 and TEOS was 1:1 in terms of mass ratio. In addition, in Example 13, MS51 was used as an alkyl silicate. In the other examples and Comparative Examples 1 to 10, the same tetraethoxysilane (TEOS) as in Example 1 was used.

The mixing proportions of the alkyl silicate in the alkyl silicate solution of Examples 2 to 21 and Comparative Examples 1 to 10 were the same as in Example 1 or changed as shown in Table 1. The proportions of the molar concentration of pure water with respect to Si in alkyl silicate in Examples 2 to 21 and Comparative Examples 1 to 10 were the same as in Example 1 or changed as shown in Table 1. The organic solvents of Examples 2 to 21 and Comparative Examples 1 to 10 were the same as in Example 1 or changed as shown in Table 1. As the organic solvents, propylene glycol monomethyl ether was used in Example 4 and Comparative Example 6, methanol was used in Examples 14 and 21, 2-propanol was used in Example 15, n-propanol was used in Example 16, ethylene glycol was used in Example 17, and butanol was used in Example 18. In the other examples and Comparative Examples 1 to 5 and 7 to 10, the same ethanol as in Example 1 was used.

As shown in Table 2, at the time of preparing raw material liquids of Examples 2 to 21 and Comparative Examples 1 to 10, the kinds of alkali catalysts were the same as in Example 1 or changed. The alkali catalysts were all alkaline aqueous solutions. As the alkali catalysts, magnesium hydroxide (Mg(OH)₂) was used in Comparative Example 1, a liquid obtained by mixing aluminum chloride (AlCl₃) hexahydrate and ammonia (NH₃) water so that Al and N in the solution reached 1: 1 was used in Comparative Example 2. In addition, the proportions of the alkali catalyst added to silica when alkyl silicate was converted to silica were the same as in Example 1 or changed. Furthermore, as shown in Table 2, at the time of heating raw material liquids of Examples 2 to 21 and Comparative Examples 1 to 10, the temperatures and the times were the same as in Example 1 or changed. Chainlike colloidal silica dispersion sols of Examples 2 to 21 and Comparative Examples 1 to 10 were each obtained under such production conditions.

### <Comparative Example 11>

In Comparative Example 11, a chainlike colloidal silica dispersion sol was obtained by a method according to Example 1 of Patent Literature 1. Specifically, a colloid aqueous solution of activated silicate was obtained by passing a sodium silicate aqueous solution having a SiO₂ concentration of 3.6 mass% through a column filled with a cation exchange resin. 2000 g of this colloid aqueous solution of activated silicate was injected into a glass container, and 8.0 g of a 10 mass% calcium chloride aqueous solution was then added dropwise to and mixed with the aqueous solution under stirring. After 30 minutes, 12.0 g of a 10 mass% sodium hydroxide aqueous solution was further added dropwise while stirring the liquid mixture to prepare a raw material liquid. This raw material liquid was put into a stainless steel autoclave and heated at 130°C for six hours, and the contents were then removed, thereby obtaining a chainlike colloidal silica dispersion sol.

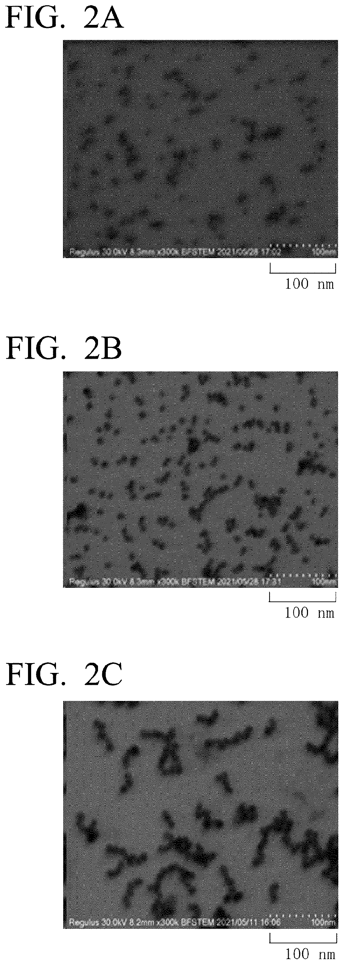

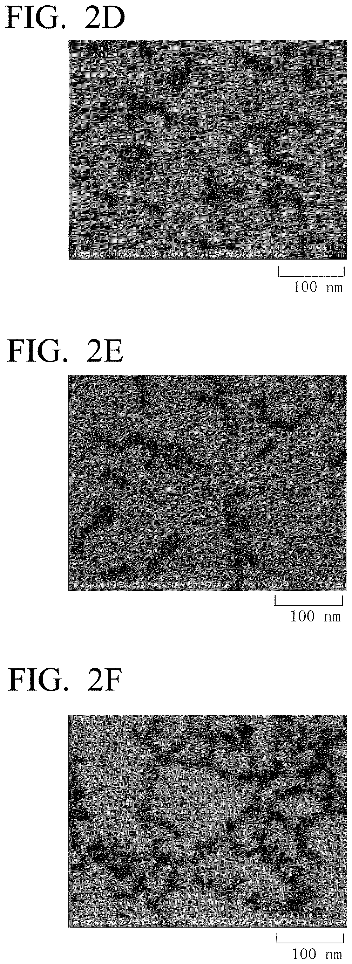

FIG. 2A to FIG. 2F are FE-SEM photographs showing the statuses of particle growth from after one hour of heating to after 96 hours of heating in Example 1. FIG. 2A to FIG. 2F each show the FE-SEM photograph of a state where the particles had been dispersed after one hour of heating when the raw material liquid of Example 1 was heated (FIG. 2A), after six hours of heating (FIG. 2B), after 24 hours of heating (FIG. 2C), after 48 hours of heating (FIG. 2D), after 72 hours of heating (FIG. 2E) or after 96 hours of heating (FIG. 2F).

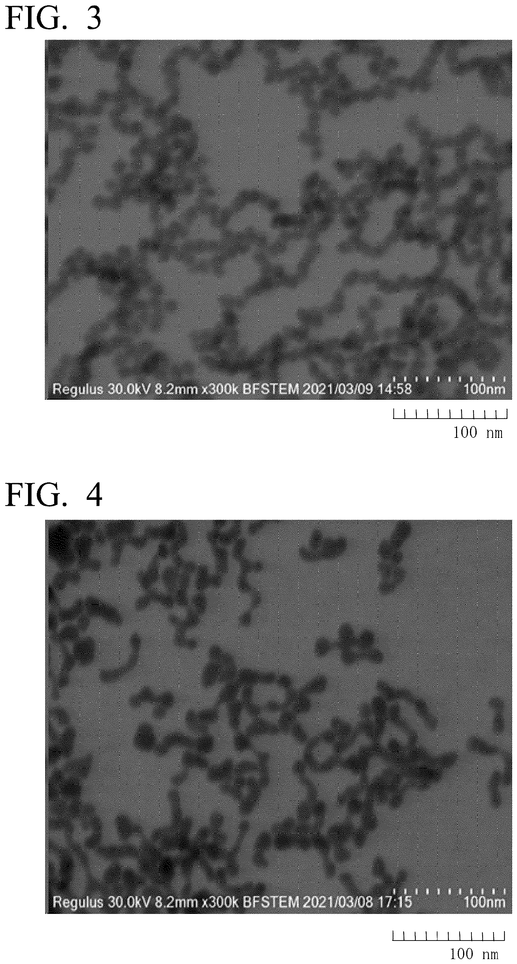

FIG. 3 shows an FE-SEM photograph after the raw material liquid of Example 2 was heated for 24 hours. Furthermore, FIG. 4 shows an FE-SEM photograph of a state where the particles were dispersed after the raw material liquid of Comparative Example 11 was heated for six hours.

### <Evaluation>

### (1) State of colloidal silica particles after heating of raw material liquid

The states of the colloidal silica particles after one hour of heating (heating initial stage) and at the end of heating (final) of the raw material liquids of Examples 1 to 21 and Comparative Examples 1 to 11 were observed using the above-described FE-SEM. The results are shown in Table 3 below. The state of the colloidal silica particles after one hour of heating, which is the heating initial stage, in Example 1 is shown in FIG. 2A. The average particle diameter of the primary particles of the colloidal silica particles of Example 1 was 4 nm, and the average aspect ratio thereof was 1.0. In addition, the primary particles failed to become chainlike. The state of the colloidal silica particles after 96 hours of heating at the end of heating is shown in FIG. 2F. The primary particles of the colloidal silica particles of Example 1 were spherical, had an average particle diameter of 10 nm and had an average aspect ratio of 1.1, and an average of 70 primary particles chainly connected to have an average length of 700 nm. The state of the colloidal silica particles after 24 hours of heating at the end of heating in Example 2 is shown in FIG. 3. The state of the colloidal silica particles after six hours of heating at the end of heating in Comparative Example 11 is shown in FIG. 4. As shown in Table 3, the primary particles of the colloidal silica particles after six hours of heating at the end of heating in Comparative Example 11 were not spherical, had an average particle diameter of 12 nm and had an average aspect ratio of 1.4, and an average of four primary particles chainly connected to have an average length of 50 nm. This is assumed to be because dissolved calcium ions elute the surfaces of the silica particles.

**[Table 3]**

| | State of colloidal silica particles in heating initial stage | | State of colloidal silica particles after heating stage | | | |
|---|---|---|---|---|---|---|
| | Average particle diameter of primary particles (nm) | Average aspect ratio of primary particles (major axis/minor axis) | Average length of chains (nm) | Average particle diameter of primary particles (nm) | Average aspect ratio of primary particles (major axis/minor axis) | Average number of primary particles connected (particles) |
| Example 1 | 4 | 1.0 | 700 | 10 | 1.1 | 70 |
| Example 2 | 4 | 1.0 | 35 | 7 | 1.1 | 5 |
| Example 3 | 3 | 1.0 | 1800 | 9 | 1.1 | 110 |
| Example 4 | 3 | 1.0 | 800 | 6 | 1.1 | 133 |
| Example 5 | 3 | 1.0 | 400 | 20 | 1.1 | 20 |
| Example 6 | 3 | 1.0 | 350 | 15 | 1.3 | 23 |
| Example 7 | 3 | 1.0 | 40 | 10 | 1.1 | 4 |
| Example 8 | 2 | 1.0 | 1800 | 6 | 1.1 | 300 |
| Example 9 | 2 | 1.0 | 100 | 6 | 1.1 | 16 |
| Example 10 | 5 | 1.1 | 600 | 10 | 1.1 | 60 |
| Example 11 | 4 | 1.0 | 600 | 10 | 1.1 | 60 |
| Example 12 | 4 | 1.0 | 100 | 12 | 1.1 | 8 |
| Example 13 | 4 | 1.0 | 1000 | 11 | 1.1 | 91 |
| Example 14 | 4 | 1.0 | 800 | 10 | 1.1 | 80 |
| Example 15 | 4 | 1.0 | 700 | 10 | 1.1 | 70 |
| Example 16 | 4 | 1.0 | 750 | 10 | 1.1 | 75 |
| Example 17 | 4 | 1.0 | 600 | 10 | 1.1 | 60 |
| Example 18 | 4 | 1.0 | 650 | 10 | 1.1 | 65 |
| Example 19 | 2 | 1.0 | 1000 | 12 | 1.1 | 83 |
| Example 20 | 2 | 1.0 | 1000 | 15 | 1.1 | 67 |
| Example 21 | 2 | 1.0 | 1500 | 10 | 1.1 | 150 |
| Comparative Example 1 | 5 | 1.0 | 250 | 30 | 1.1 | 9 |
| Comparative Example 2 | 5 | 1.0 | 400 | 30 | 1.1 | 14 |
| Comparative Example 3 | 2 | 1.0 | 20 | 10 | 1.1 | 2 |
| Comparative Example 4 | 3 | 1.0 | 2500 | 10 | 1.1 | 250 |
| Comparative Example 5 | 2 | 1.0 | 80 | 4 | 1.1 | 20 |
| Comparative Example 6 | 7 | 1.1 | 250 | 35 | 1.3 | 15 |
| Comparative Example 7 | 7 | 1.2 | 200 | 40 | 1.4 | 5 |
| Comparative Example 8 | 5 | 1.0 | 90 | 30 | 1.2 | 3 |
| Comparative Example 9 | 3 | 1.0 | 3200 | 8 | 1.1 | 400 |
| Comparative Example 10 | 10 | 1.0 | 4000 | 500 | 2.0 | 10 |
| Comparative Example 11 | 5 | 1.1 | 50 | 12 | 1.4 | 4 |

### (2) Content proportion of impurity in colloidal silica particles

The content proportions of the impurities in the colloidal silica particles of Examples 1 to 21 and Comparative Examples 1 to 11 were measured using the above-described ICP optical emission mass spectrometer and ammonia meter. The results are shown in Table 4 below. In the colloidal silica particles of Example 1, since KOH was used as the alkali catalyst, the K concentration per colloidal silica particle was 850 ppm by mass. The concentrations of Na, NH₃, Ca, Mg and Al were all less than 1 ppm by mass, which was less than the detection limit. In Table 4, "<1" indicates that the content proportion of the impurity is less than 1 ppm by mass.

**[Table 4]**

| | Content proportion of impurity per colloidal silica particle (ppm by mass) | | | | | | Evaluation | | |
|---|---|---|---|---|---|---|---|---|---|
| | K | Na | NH₃ | Alkali earth metal | | Al | Storage stability of chainlike colloidal silica dispersion sol | Coated film | |
| | | | | Ca | Mg | | | Refractive index | Variation in refractive index (%) |
| Example 1 | 850 | <1 | <1 | <1 | <1 | <1 | Favorable | 1.10 | 1 |
| Example 2 | <1 | 700 | <1 | <1 | <1 | <1 | Favorable | 1.25 | 2 |
| Example 3 | <1 | 700 | <1 | <1 | <1 | <1 | Favorable | 1.17 | 1 |
| Example 4 | <1 | 700 | <1 | <1 | <1 | <1 | Favorable | 1.17 | 2 |
| Example 5 | <1 | 700 | <1 | <1 | <1 | <1 | Favorable | 1.25 | 1 |
| Example 6 | <1 | 700 | <1 | <1 | <1 | <1 | Favorable | 1.23 | 1 |
| Example 7 | <1 | 350 | <1 | <1 | <1 | <1 | Favorable | 1.24 | 2 |
| Example 8 | <1 | <1 | 990 | <1 | <1 | <1 | Favorable | 1.18 | 1 |
| Example 9 | <1 | 117 | <1 | <1 | <1 | <1 | Favorable | 1.22 | 2 |
| Example 10 | <1 | <1 | 2880 | <1 | <1 | <1 | Favorable | 1.22 | 1 |
| Example 11 | 850 | <1 | <1 | <1 | <1 | <1 | Favorable | 1.19 | 1 |
| Example 12 | 850 | <1 | <1 | <1 | <1 | <1 | Favorable | 1.25 | 2 |
| Example 13 | 850 | <1 | <1 | <1 | <1 | <1 | Favorable | 1.20 | 1 |
| Example 14 | 850 | <1 | <1 | <1 | <1 | <1 | Favorable | 1.20 | 1 |
| Example 15 | 850 | <1 | <1 | <1 | <1 | <1 | Favorable | 1.21 | 1 |
| Example 16 | 850 | <1 | <1 | <1 | <1 | <1 | Favorable | 1.21 | 1 |
| Example 17 | 850 | <1 | <1 | <1 | <1 | <1 | Favorable | 1.24 | 1 |
| Example 18 | 850 | <1 | <1 | <1 | <1 | <1 | Favorable | 1.22 | 1 |
| Example 19 | <1 | <1 | 542 | <1 | <1 | <1 | Favorable | 1.20 | 1 |
| Example 20 | <1 | <1 | 373 | <1 | <1 | <1 | Favorable | 1.21 | 1 |
| Example 21 | <1 | <1 | 285 | <1 | <1 | <1 | Favorable | 1.19 | 1 |
| Comparative Example 1 | <1 | <1 | <1 | <1 | 420 | <1 | Poor | - | - |
| Comparative Example 2 | <1 | <1 | 990 | <1 | <1 | 1000 | Poor | - | - |
| Comparative Example 3 | <1 | 12 | <1 | <1 | <1 | <1 | Favorable | 1.30 | 3 |
| Comparative Example 4 | <1 | 700 | <1 | <1 | <1 | <1 | Poor | - | - |
| Comparative Example 5 | <1 | 700 | <1 | <1 | <1 | <1 | Favorable | 1.30 | 2 |
| Comparative Example 6 | <1 | 700 | <1 | <1 | <1 | <1 | Favorable | 1.37 | 2 |
| Comparative Example 7 | <1 | 700 | <1 | <1 | <1 | <1 | Favorable | 1.38 | 2 |
| Comparative Example 8 | <1 | <1 | 490 | <1 | <1 | <1 | Favorable | 1.30 | 2 |
| Comparative Example 9 | <1 | 700 | <1 | <1 | <1 | <1 | Poor | - | - |
| Comparative Example 10 | <1 | 4020 | <1 | <1 | <1 | <1 | Poor | - | - |
| Comparative Example 11 | <1 | 5886 | <1 | 3843 | <1 | <1 | Poor | 1.20 | 5 |

### (3) Storage stability of chainlike colloidal silica dispersion sol

The storage stability of each of the chainlike colloidal silica dispersion sols of Examples 1 to 21 and Comparative Examples 1 to 11 was visually confirmed by putting this dispersion sol into a transparent glass container and placing the dispersion sol still for one month in an environment of 25°C and a relative humidity of 60%. In a case where no aggregates appeared in the dispersion sol and the dispersion sol did not gelate, the storage stability was determined as "favorable", and, in a case where an aggregate appeared in the dispersion sol or the dispersion sol gelated, the storage stability was determined as "poor." The results are shown in Table 4.

### (4) Refractive index of coated film

The chainlike colloidal silica dispersion sols of Examples 1 to 21 and Comparative Examples 1 to 11 were applied by a spin coating method to glass substrates so that the dried thickness reached 0.15 µm and dried at a temperature of 120°C for 30 minutes. The refractive indexes of the coated films formed on the glass substrates were measured using the above-described spectroscopic ellipsometer. The results are shown in Table 4. The variation in the refractive index of the film was calculated from the following expression (1) after the refractive indexes were measured at three different places in the film.

### [(Maximum value - minimum value)/average value] × 100% (1)

In the case of "less than ±5%", the variation in the refractive index of the film was determined to be favorable, and, in the case of "±5% or more", the variation in the refractive index of the film was determined to be poor. In Table 4, "-" indicates that the measurement is not possible.

### <Evaluation results>

As is clear from Table 4, in Comparative Example 1, since magnesium hydroxide (Mg(OH)₂) was used as the alkali catalyst, dissolved magnesium ions were eluted from the surfaces of the silica particles, and the generation of coarse particles was promoted, whereby the particles coarsened, and the average particle diameter of the primary particles became 30 nm, which was too large. The average chain length of the colloidal silica particles was 250 nm, and the average number of particles connected was nine. Therefore, the coarse particles aggregated and did not disperse, it was not possible to form a coated film on the glass substrate, and it was not possible to measure the refractive index of the film. In addition, the content proportion of the magnesium (Mg) impurity in the colloidal silica particles was 420 ppm by mass. The storage stability of the dispersion sol was "poor."

In Comparative Example 2, since a mixture of aluminum chloride hexahydrate and ammonia water was used as the alkali catalyst, aluminum ions, which acted as an impurity, were eluted from the surfaces of the silica particles, and the generation of coarse particles was promoted, whereby the colloidal silica particles coarsened, the average particle diameter of the primary particles became 30 nm, the average chain length of the colloidal silica particles was 400 nm, and the average number of particles connected was 14. Therefore, the coarse particles aggregated and did not disperse, it was not possible to form a coated film on the glass substrate, and it was not possible to measure the refractive index of the film. In addition, the content proportion of the NH₃ impurity in the colloidal silica particles was 990 ppm by mass, and the content proportion of the aluminum (Al) impurity was 1000 ppm by mass. The storage stability of the dispersion sol was "poor."

In Comparative Example 3, since the concentration of NaOH, which was the alkali catalyst, was 0.01 mass%, which was too low, the reactivity was poor, spherical primary particles were not sufficiently generated, the average length of the chains of the colloidal silica particles was 20 nm, which was too short, and the average number of primary particles connected was two, which was too small. Therefore, it was possible to form a coated film, but the refractive index of the film was as high as 1.30. In addition, the content proportion of the sodium (Na) impurity in the colloidal silica particles was 12 ppm by mass. The storage stability of the dispersion sol was "favorable."

In Comparative Example 4, since the proportion of tetraethoxysilane mixed was 60.8 mass%, which was too large, with respect to the tetraethoxysilane solution, which made the proportion of pure water with respect to Si in tetraethoxysilane reach 4.2 molar concentrations, the tetraethoxysilane solution gelated. Therefore, the average number of primary particles connected was 250, but the average length of the chains of the colloidal silica particles was 2500 nm, which was too large, it was not possible to form a coated film on the glass substrate, and it was not possible to measure the refractive index of the film. In addition, the content proportion of the sodium (Na) impurity in the colloidal silica particles was 700 ppm by mass. The storage stability of the dispersion sol was "poor."

In Comparative Example 5, since the proportion of tetraethoxysilane mixed was 8.7 mass%, which was too small, with respect to the tetraethoxysilane solution, which made the proportion of pure water with respect to Si in tetraethoxysilane reach 64.0 molar concentrations, in the heating step, spherical primary particles did not sufficiently increase, and the average particle diameter of the primary particles was 4 nm, which was too small. The average number of primary particles connected was 20, the average length of the chains of the colloidal silica particles was 80 nm, and it was possible to form a coated film, but the spherical particles aggregated, and the refractive index of the film was thus as high as 1.30. In addition, the content proportion of the sodium (Na) impurity in the colloidal silica particles was 700 ppm by mass. While the spherical particles aggregated, the average length of the chains was short, and the storage stability of the dispersion sol was thus "favorable."

In Comparative Example 6, since the proportion of tetraethoxysilane mixed was 34.8 mass%, which was appropriate, with respect to the tetraethoxysilane solution, but the proportion of pure water with respect to Si in tetraethoxysilane was 1.6 molar concentrations, which was too small. Therefore, primary particles coarsened, and the average particle diameter of the primary particles reached 35 nm, which was too large. The average number of primary particles connected was 15, the average length of the chains of the colloidal silica particles was 250 nm, and it was possible to form a coated film, but the spherical particles were coarse, and the refractive index of the film was thus as high as 1.37. In addition, the content proportion of the sodium (Na) impurity in the colloidal silica particles was 700 ppm by mass. The storage stability of the dispersion sol was "favorable."

In Comparative Example 7, since the proportion of tetraethoxysilane mixed was 34.8 mass%, which was appropriate, with respect to the tetraethoxysilane solution, but the proportion of pure water with respect to Si in tetraethoxysilane was 1.6 molar concentrations, which was too small. Therefore, primary particles coarsened, the average particle diameter of the primary particles reached 40 nm, which was too large, and the average aspect ratio of the primary particles reached 1.4, which was too large. The average number of primary particles connected was five, the average length of the chains of the colloidal silica particles was 200 nm, and it was possible to form a coated film, but the spherical particles had aggregated, and the refractive index of the film was thus as high as 1.38. In addition, the content proportion of the sodium (Na) impurity in the colloidal silica particles was 700 ppm by mass. The storage stability of the dispersion sol was "favorable."

In Comparative Example 8, since the concentration of ammonia (NH₃), which was the alkali catalyst, was 0.60 mass%, which was too high, the reaction rate of the hydrolysis of tetraethoxysilane significantly increased, spherical primary particles coarsened, and the average particle diameter of the primary particles reached 30 nm, which was too large. The average aspect ratio of the primary particles was 1.2. The average length of the chains of the colloidal silica particles was 90 nm, and the average number of primary particles connected was only slightly three aggregated particles. Therefore, it was possible to form a coated film, but the refractive index of the film was as high as 1.30. In addition, the content proportion of the NH₃ impurity in the colloidal silica particles was 490 ppm by mass. The storage stability of the dispersion sol was "favorable."

In Comparative Example 9, since the proportion of tetraethoxysilane mixed was 69.5 mass%, which was too large, with respect to the tetraethoxysilane solution, which made the proportion of pure water with respect to Si in tetraethoxysilane reach 2.9 molar concentrations, the tetraethoxysilane solution gelated. The average number of primary particles connected became as extremely large as 400, the average length of the chains of the colloidal silica particles reached 3200 nm, which was too long. Therefore, it was not possible to form a coated film on the glass substrate, and it was not possible to measure the refractive index of the film. In addition, the content proportion of the sodium (Na) impurity in the colloidal silica particles was 700 ppm by mass. The storage stability of the dispersion sol was "poor."

In Comparative Example 10, since the concentration of NaOH, which was the alkali catalyst, was 0.70 mass%, which was too high, the reaction rate of the hydrolysis of tetraethoxysilane significantly increased, spherical primary particles coarsened, and the primary particle average particle diameter reached 500 nm, which was too large. The average length of the chains of the colloidal silica particles was 4000 nm, and aggregated particles in which the average number of primary particles connected was 10 were obtained. The average aspect ratio of the primary particles reached 2.0, which was too large. Since coarse spherical particles aggregated, it was not possible to form a coated film on the glass substrate, and it was not possible to measure the refractive index of the film. In addition, the content proportion of the sodium (Na) impurity in the colloidal silica particles was 4020 ppm by mass. The storage stability of the dispersion sol was "poor."

In Comparative Example 11, since a sodium silicate (Na silicate) aqueous solution was used instead of the alkyl silicate, and a calcium chloride aqueous solution was added to this sodium silicate aqueous solution, at the time of particle synthesis, the concentration of the sodium (Na) impurity was 9691 ppm by mass, and the concentration of calcium (Ca) was 4052 ppm by mass. In addition, due to concentration, the concentration of the Na impurity increased to 5886 ppm by mass, and the concentration of Ca increased to 3843 ppm by mass. However, since sodium ions and calcium ions, which were the impurities, were eluted from the surfaces of the silica particles and needle-like impurities were precipitated as time passed, particles having an extremely large average aspect ratio of 1.4 were observed. In addition, the storage stability of the sol was "poor." Since gelation or an increase in the viscosity did not occur in the dispersion sol, it was possible to form a coated film, and the refractive index of the film was 1.20, but the thicknesses of the chains were not uniform, the numbers of particles connected also varied, and the variation in the refractive index of the film was as extremely large as 5%.

In contrast to these, in Examples 1 to 21, since the chainlike colloidal silica dispersion sols were produced under conditions where the above-described production conditions of the second aspect of the present invention were satisfied, it was possible to obtain chainlike colloidal silica dispersion sols having the characteristics of the first aspect of the present invention.

### INDUSTRIAL APPLICABILITY

The chainlike colloidal silica dispersion sol of the present invention can be used in a field where an antireflection film that is used to prevent the reflection of light in cathode ray tubes, liquid crystals, display panels such as organic Els, solar cells, showcasting glass and the like or in a field where an interlayer film for which a refractive index difference is used and that is used in sensors, camera modules and the like or the like is formed.

### REFERENCE SIGNS LIST

11 Solvent mixture of pure water and organic solvent
12 Alkyl silicate
13 Alkyl silicate solution
14 Alkali catalyst
15 Raw material liquid
16 Chainlike colloidal silica dispersion sol

## Claims

1. A chainlike colloidal silica dispersion sol formed by dispersing a group of colloidal silica particles having an average length of 35 nm to 1800 nm and an average of 4 to 300 spherical primary particles chainly connected that are grasped by field emission scanning electron microscopic observation in a solvent mixture of pure water and an organic solvent,
wherein an average particle diameter of the spherical primary particles is 6 nm to 20 nm, an average aspect ratio of the spherical primary particles is within a range of 1.0 to 1.3,
the organic solvent is an alcohol having 1 to 4 carbon atoms or a water-soluble glycol compound having 2 to 4 carbon atoms,
a content proportion of each impurity of K, Na or NH₃ per colloidal silica particle is 3500 ppm by mass or less, and a content proportion of each impurity of an alkali earth metal or aluminum is less than 1 ppm by mass.

2. A method for producing the chainlike colloidal silica dispersion sol according to Claim 1, the method comprising:
a step (a) of mixing an alkyl silicate having an alkyl group having 1 or 2 carbon atoms with a solvent mixture of pure water and an organic solvent to obtain an alkyl silicate solution;
a step (b) of adding and mixing an alkali catalyst to and with the alkyl silicate solution to obtain a raw material liquid; and
a step (c) of heating the raw material liquid at 40°C to 100°C for 24 hours to 100 hours,
wherein the pure water is contained in the solvent mixture in a proportion of 8 molar concentrations to 23 molar concentrations with respect to Si in the alkyl silicate,
the organic solvent is an alcohol having 1 to 4 carbon atoms or a water-soluble glycol compound having 2 to 4 carbon atoms,
in the step (a), when the alkyl silicate solution is set to 100 mass%, the alkyl silicate is mixed in a proportion of 18 mass% to 44 mass%,
in the step (b), when the alkyl silicate is converted to silica, the alkali catalyst is mixed in a proportion of 0.02 mass% to 0.40 mass% with respect to the silica, and
the alkali catalyst is an alkali metal hydroxide, ammonia or an alkylamine.

3. The method for producing a chainlike colloidal silica dispersion sol according to Claim 2,
wherein, in a heating initial stage of the step (c), spherical primary particles having an average aspect ratio of 1.0 to 1.1 and an average particle diameter of less than 5 nm are formed, and, at an end of the heating, the spherical primary particles in the heating initial stage have an average particle diameter of 6 nm to 20 nm and an average of 4 to 300 spherical primary particles chainly connected and grow to a group of colloidal silica particles having an average length of 35 nm to 1800 nm.

4. A film that is obtained using the chainlike colloidal silica dispersion sol according to Claim 1,
wherein a refractive index is 1.10 to 1.25.
